# DEMANDE DE BREVET EUROPEEN

(11) **EP 4 651 672 A1**
(43) Date de publication de la demande: **19.11.2025**
(21) Numéro de dépôt: 25176889.1
(22) Date de dépôt: 16.05.2025
(51) Int. Cl.: H10D 64/23, H01L 23/482, H10D 30/47, H10D 8/60, H10D 62/10, H10D 62/85

(54) **DISPOSITIFS MICROÉLECTRONIQUES DE PUISSANCE LATÉRAUX**

(30) Priorité: 16.05.2024 FR 2405037
(71) Demandeur: Commissariat à l'Energie Atomique et aux Energies Alternatives, 75015 Paris (FR)
(72) Inventeur: BUCKLEY, Julien, 38054 GRENOBLE Cedex 09 (FR); BISCARRAT, Jérôme, 38054 GRENOBLE Cedex 09 (FR); CHARLES, Matthew, 38054 GRENOBLE Cedex 09 (FR); EL AMRANI, Mohammed, 38054 GRENOBLE Cedex 09 (FR); KALTSOUNIS, Thomas, 38054 GRENOBLE Cedex 09 (FR)
(74) Mandataire: Hautier IP

(57) **Abrégé**

L'invention porte sur un dispositif microélectronique comprenant :
- Un substrat (1),
- Un ilot (2) à base de GaN surmontant le substrat, en saillie,
- Au moins un premier contact (31), par exemple un drain ou une cathode, sur la face supérieure (200) de l'ilot (2),
- Au moins un deuxième contact (32), par exemple une source ou une anode, disposé sur la face supérieure (200) de l'ilot (2) et le long d'un bord (202) de ladite face supérieure (200). Le deuxième contact (32) entoure au moins partiellement le premier contact (31). Avantageusement, le deuxième contact (32) et le substrat (1) sont configurés pour être polarisés selon une même polarisation lors d'un fonctionnement du dispositif.

Un procédé de fabrication d'un tel dispositif est également proposé.

## Description

### DOMAINE TECHNIQUE

La présente invention concerne le domaine de la microélectronique. Elle trouve pour application particulièrement avantageuse la conception de transistors de puissance et de diodes de puissance à conduction latérale, à base de GaN.

### ETAT DE LA TECHNIQUE

Les architectures dites « latérales » visent à contrôler le passage d'un courant latéralement entre deux contacts disposés sensiblement sur une même face. Dans du nitrure de gallium (GaN), ce courant correspond à un gaz bidimensionnel d'électrons (2DEG) confiné sous une interface avec une couche barrière généralement à base d'AlGaN. Dans le cas d'un transistor de puissance latéral, une grille, qui peut être enterrée ou semi-enterrée, est typiquement interposée sur le chemin de conduction du gaz 2DEG entre la source et le drain. Dans le cas d'une diode de puissance latérale, l'anode forme typiquement un contact Schottky avec le GaN, au niveau du gaz 2DEG. Le document « Performance enhancement of CMOS compatible 600V rated AlGaN/GaN Schottky diodes on 200mm Silicon wafers, J. Biscarrat et al, Proceedings of the 30th International Symposium on Power Semiconductor Devices & lCs, May 13-17, 2018, Chicago, USA » divulgue une telle architecture de diode de puissance à conduction latérale à base de GaN. Ce type d'architectures latérales permet une intégration améliorée des composants de puissance.

Ces architectures latérales présentent cependant une tension maximale de fonctionnement limitée. La faible épaisseur de GaN liée à ce type d'architectures latérales induit une tension de claquage relativement peu élevée, de l'ordre de quelques dizaines à quelques centaines de volts typiquement inférieure à 900V. Différentes architectures alternatives de dispositifs de puissance ont été développées pour pallier cet inconvénient.

Le document « 1900V, 1.6mΩcm2 AIN/GaN-on-Si power devices realized by local substrate removal, Nicolas Herbecq et al, Applied Physics Express 7, 034103 (2014) » divulgue une architecture latérale de transistor de puissance dans laquelle le substrat de silicium supportant les couches de matériaux III-V a été localement retiré, sous le chemin de conduction du transistor entre la grille et le drain. Cela permet de limiter le courant de fuite et d'augmenter en conséquence la tenue en tension du composant. Le composant est en partie suspendu, ce qui le rend plus fragile mécaniquement. L'intégration d'un tel composant est en outre limitée.

Le document « Selective-area growth study of GaN micropillars for quasi-vertical Schottky diodes, A Debald et al, Semicond. Sci. Technol. 36 (2021) 034005 » divulgue une architecture de diode dite « verticale » ou « quasi-verticale ». Dans ce type d'architecture verticale, l'épaisseur de GaN est plus importante et la tenue en tension du composant est améliorée. Ce type d'architecture est cependant encombrant. L'apparition d'un courant de fuite limite en outre le rapport lon/loff (courant à l'état passant Ion vs courant à l'état bloquant loff). La gestion des champs électriques sur les bords de la structure en mésa est complexe, ce qui limite également le courant à l'état passant.

Un objet de la présente invention est de proposer une architecture de dispositifs de puissance surmontant les inconvénients mentionnés ci-dessus.

En particulier, un objet de la présente invention est de proposer une architecture latérale de dispositifs de puissance présentant une tenue en tension améliorée.

Un autre objet de la présente invention est de proposer un procédé de fabrication d'une telle architecture latérale de dispositifs de puissance.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un dispositif microélectronique comprenant :
- Un substrat à base d'au moins un matériau semiconducteur,
- Un ilot à base de nitrure de gallium GaN surmontant le substrat, en saillie, et présentant une face dite supérieure et des flancs entourant l'ilot,
- Au moins un premier contact, par exemple un drain ou une cathode, sur la face supérieure de l'ilot,
- Au moins un deuxième contact, par exemple une source ou une anode.

Avantageusement, l'au moins un deuxième contact est disposé sur la face supérieure de l'ilot et le long d'un bord de ladite face supérieure, de sorte que l'au moins un deuxième contact entoure au moins partiellement l'au moins un premier contact. Avantageusement, l'au moins un deuxième contact et le substrat sont configurés pour être polarisés selon une même polarisation lors d'un fonctionnement du dispositif.

Le dispositif microélectronique présente ainsi une architecture latérale, où l'ensemble des contacts est disposé sur la face supérieure de l'ilot. Le dispositif bénéficie notamment des avantages d'une telle architecture latérale, par exemple une efficacité énergétique élevée et une fréquence de fonctionnement élevée. L'architecture latérale permet notamment d'obtenir une mobilité électronique élevée grâce au gaz bidimensionnel d'électrons. La technologie de fabrication des composants à architecture latérale est en outre plus mature que les autres architectures pour le GaN, notamment les architectures verticales ou quasi-verticales. La formation des différentes couches d'une architecture latérale est plus rapide que la formation des différentes couches d'une architecture verticale, car il n'est pas nécessaire de gérer de très faibles niveaux de dopage, comme c'est le cas pour des composants à architecture verticale.

Par ailleurs, la disposition du deuxième contact en bordure de l'ilot, polarisé de la même façon que le substrat, permet de limiter voire supprimer les courants de fuite le long des flancs de l'ilot. La tenue en tension du dispositif à architecture latérale est ainsi améliorée.

Selon une possibilité, l'ilot à base de GaN présente une hauteur de plusieurs micromètres, typiquement supérieure ou égale à 5 µm. Cela permet également de renforcer la tenue en tension du dispositif.

Un autre aspect de l'invention concerne un système comprenant une pluralité de dispositifs adjacents les uns les autres et partageant le même substrat. Avantageusement, les ilots des dispositifs sont séparés les uns des autres par une distance inférieure à 10 µm, entre deux flancs de deux ilots adjacents. Le système est compact. L'intégration des dispositifs est ainsi améliorée.

Selon un autre aspect de l'invention, on prévoit un procédé de fabrication d'au moins un dispositif microélectronique tel que décrit ci-dessus. Ce procédé comprend notamment les étapes suivantes :
- Former par épitaxie localisée au moins un ilot à base de GaN sur un substrat à base d'au moins un matériau semiconducteur,
- Former au moins un premier contact sur la face supérieure dudit au moins un ilot,
- Former au moins un deuxième contact sur la face supérieure, en bordure dudit au moins un ilot.

L'architecture latérale du dispositif microélectronique est particulièrement adaptée pour un ou des ilots formés par épitaxie localisée. L'épitaxie localisée permet typiquement d'obtenir une pluralité d'ilots répartis selon un réseau compact, et une hauteur de plusieurs micromètres pour chacun des ilots à base de GaN. La conjonction d'un tel procédé de fabrication avec une architecture latérale permet avantageusement d'obtenir des dispositifs microélectroniques présentant une tenue en tension améliorée, avec une densité d'intégration élevée.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A, 1B illustrent schématiquement, respectivement en vue de dessus et en coupe transverse, un dispositif microélectronique de puissance comprenant des diodes Schottky, selon un mode de réalisation de la présente invention.
Les figures 2A, 2B illustrent schématiquement, respectivement en vue de dessus et en coupe transverse, un dispositif microélectronique de puissance comprenant des transistors HEMT, selon un autre mode de réalisation de la présente invention.
La figure 3 illustre schématiquement, en coupe transverse, une étape de formation par épitaxie localisée d'ilots à base de GaN, selon un mode de réalisation de la présente invention.
Les figures 4A, 4B correspondent à des images de microscopie électronique à balayage, en vue de dessus, d'ilots à base de GaN obtenus par épitaxie localisée, selon un mode de réalisation de la présente invention.
Les figures 5 à 16 illustrent schématiquement, en coupe transverse, des étapes de fabrication d'un dispositif microélectronique de puissance comprenant des transistors HEMT, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des différents éléments (ilots, contacts etc) ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif comprend en outre une couche barrière, par exemple à base d'AlGaN, sur la face supérieure de l'ilot. Cela permet de former un gaz 2DEG sous la couche barrière, dans l'ilot à base de GaN. La mobilité des électrons est améliorée.

Selon un exemple, l'ilot est à base de GaN sans carbone. Cela permet d'améliorer la résistance dynamique à l'état passant du dispositif.

Selon un exemple, l'au moins un premier contact et l'au moins un deuxième contact sont disposés sur la couche barrière. Selon un autre exemple, l'un parmi les premier et deuxième contacts traverse en partie ou totalement la couche barrière. Différents types de contacts, par exemple des contacts ohmiques ou des contacts Schottky, peuvent ainsi être formés sur l'ilot à base de GaN. Lorsque les contacts, typiquement les anodes, forment un contact Schottky, le fait de traverser au moins en partie la couche barrière permet de baisser la tension de seuil. Lorsque les contacts, typiquement les cathodes, forment un contact ohmique, le fait de traverser au moins en partie la couche barrière permet d'obtenir une résistance de contact indépendante de l'épaisseur de la barrière.

Selon un exemple, l'au moins un deuxième contact entoure totalement l'au moins un premier contact et forme un contour fermé autour de l'au moins un premier contact. La gestion du champ électrique en bordure d'ilot est ainsi optimisée. Les courants de fuite sont réduits ou supprimés.

Selon un exemple, l'ilot présente une hauteur supérieure ou égale à 5 µm, de préférence supérieure ou égale à 10 µm. Cela permet d'améliorer la tenue en tension du dispositif.

Selon un exemple, le dispositif comprend une pluralité de premiers contacts et une pluralité de deuxièmes contacts, les premiers et deuxièmes contacts étant disposés de façon concentrique sur la face supérieure de l'ilot. Cela permet de former différentes structures à conduction latérale imbriquées, typiquement en parallèle les unes des autres. Chaque structure bénéficie des avantages de la configuration en ilot du dispositif, avec une gestion des champs électriques optimisée.

Selon un exemple, le premier contact correspond à une cathode et le deuxième contact correspond à une anode et forme un contact Schottky avec l'ilot. Le dispositif comprend ainsi au moins une structure de type diode Schottky.

Selon un exemple, le dispositif comprend au moins une première anode au centre de l'ilot et, de façon concentrique, une première cathode entourant totalement la première anode, une deuxième anode entourant totalement la première cathode, une deuxième cathode entourant totalement la deuxième anode, et une troisième anode disposée le long du bord de la face supérieure de l'ilot et entourant totalement la deuxième cathode. Le dispositif comprend ainsi quatre diodes Schottky latérales concentriques, qui peuvent être interconnectés en parallèle.

Selon un exemple, le dispositif comprend au moins un troisième contact, par exemple une grille, disposé sur la face supérieure de l'ilot entre l'au moins un premier contact et l'au moins un deuxième contact. Le dispositif comprend ainsi au moins une structure de type transistor.

Selon un exemple, le dispositif comprend une pluralité de premiers, deuxièmes et troisièmes contacts disposés de façon concentrique sur la face supérieure de l'ilot. Le dispositif comprend ainsi au moins deux transistors latéraux en parallèle, qui peuvent être interconnectés via au moins l'un parmi les premiers et deuxièmes contacts.

Selon un exemple, le bord de l'ilot forme un contour hexagonal pour la face supérieure de l'ilot. Une telle forme hexagonale peut être typiquement obtenue par épitaxie du GaN, en particulier par épitaxie localisée. Les ilots à base de GaN peuvent présenter une hauteur de plusieurs micromètres avec la qualité cristalline requise pour des applications de microélectronique de puissance. La forme hexagonale permet en outre de réaliser un pavage compact d'ilots sur le substrat. Cela permet une bonne intégration des dispositifs dans un système plus étendu.

Selon un exemple, le système comprend une pluralité de dispositifs adjacents les uns les autres, le substrat étant commun à tous les dispositifs du système. Les ilots des dispositifs sont séparés les uns des autres par une distance inférieure à 10 µm, entre deux flancs de deux ilots adjacents. Selon un exemple, les ilots présentent une forme hexagonale et sont disposés sur le substrat selon un pavage hexagonal.

Selon un exemple, la formation par épitaxie localisée est configurée de manière à ce que l'au moins un ilot présente une hauteur supérieure ou égale à 5 µm, de préférence supérieure ou égale à 10 µm.

Selon un exemple, l'au moins un ilot comprend une pluralité d'ilots séparés les uns des autres par une distance inférieure à 10 µm, entre deux flancs de deux ilots adjacents. La formation par épitaxie localisée est d'autant mieux contrôlée que la distance entre les ilots est faible.

Il existe typiquement une synergie entre le procédé de fabrication par épitaxie localisée, et une pluralité d'ilots épais arrangés sous forme de réseau compact. Cela profite directement au dispositif et au système résultant de ce procédé de fabrication. L'architecture latérale du dispositif, parfaitement adaptée à ce type d'ilots, permet également de tirer parti des avantages du procédé de fabrication. Les différents aspects de l'invention permettent de concevoir des dispositifs microélectroniques de puissance présentant des performances et une tenue en tension optimisées.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif, le système ou le procédé, peuvent être adaptées *mutatis mutandis à* un autre aspect de l'invention.

Dans le cadre de la présente invention, les architectures de dispositifs de puissance envisagées sont qualifiées de « latérales ». Certaines de ces architectures sont plus particulièrement basées sur un principe de conduction par gaz bidimensionnel d'électrons (2DEG).

Les transistors de type HEMT (acronyme de « High Electron Mobility Transistor », qui signifie transistor à effet de champ à haute mobilité d'électrons), sont des exemples de transistors basés sur cette architecture à gaz bidimensionnel d'électrons. Pour des raisons de tenue en puissance (en particulier à haute tension) et en température, le matériau semi-conducteur de ces transistors est de préférence choisi de façon à présenter une large bande d'énergie interdite. Parmi les transistors HEMT à large bande d'énergie interdite, les transistors à base de nitrure de gallium sont généralement préférés.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par exemple et de façon connue en soi dans le domaine des transistors de type HEMT à base de GaN, une fine couche en AIN peut être intercalée entre deux couches semi-conductrices en GaN et en AlGaN.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage éventuellement indiqués dans la présente demande sont les suivantes :
- dopage p++ ou n++ : supérieur à 1 × 10²⁰cm⁻³
- dopage p+ ou n+ : 1 × 10¹³ cm⁻³ à 9 × 10¹⁹ cm⁻³
- dopage p ou n : 1 x 10¹⁷ cm⁻³ à 1 x 10¹⁸ cm⁻³
- dopage intrinsèque ou non intentionnellement dopé: 1.10¹⁵ cm⁻³ à 1.10¹⁷ cm⁻³

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, la hauteur d'un élément, typiquement un ilot en saillie d'un substrat, est prise selon z. L'épaisseur d'une couche est prise selon une direction normale au plan d'extension principal de cette couche. Ainsi, une couche peut typiquement présenter une épaisseur selon z. Les termes relatifs « sur », « surmonte », « sous », « sous-jacent », « supérieur », « inférieur » se réfèrent à des positions prises selon la direction z.

Les termes « vertical », « verticalement » se réfèrent à une direction selon z. Les termes « latéral », « latéralement » se réfèrent à une direction dans le plan xy.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de 90±10° par rapport au plan.

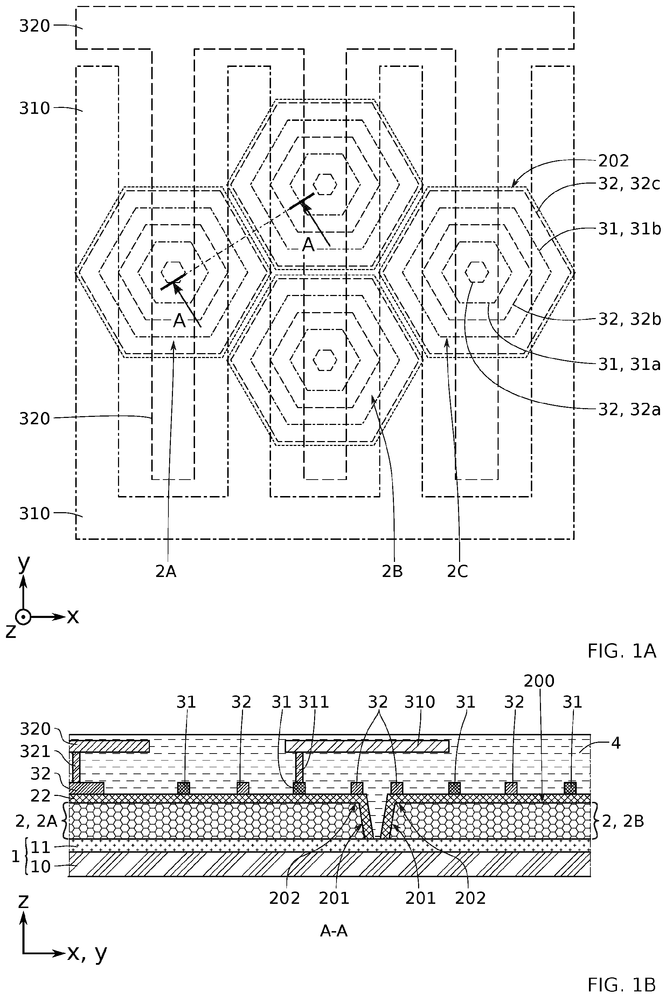

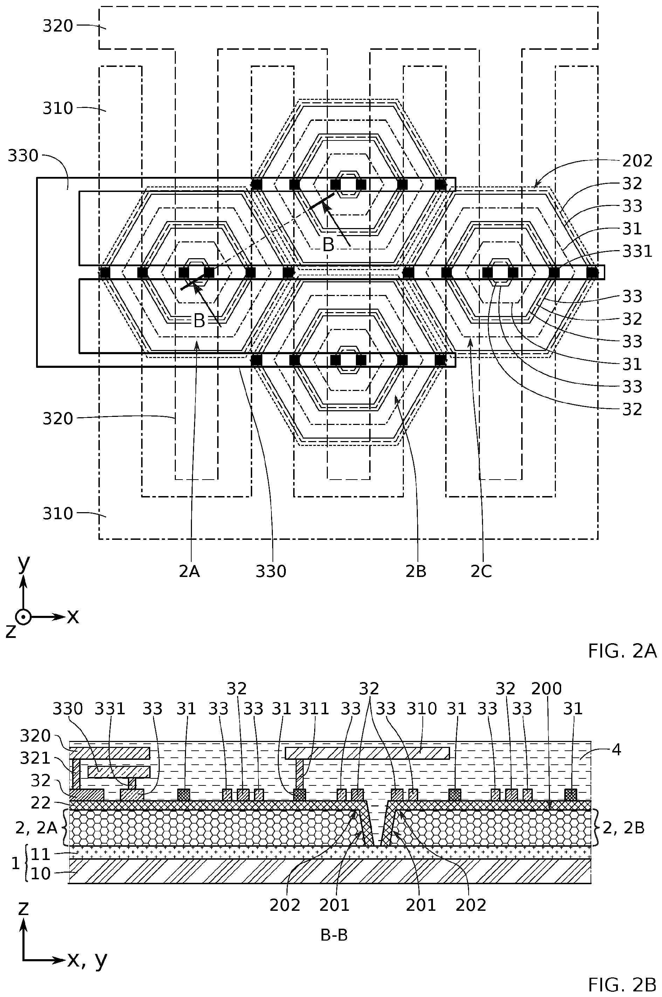

Les figures 1A, 1B illustrent respectivement en vue de dessus et en coupe transverse plusieurs dispositifs de puissance adjacents selon un premier mode de réalisation de l'invention. Les figures 2A, 2B illustrent respectivement en vue de dessus et en coupe transverse plusieurs dispositifs de puissance adjacents selon un deuxième mode de réalisation de l'invention. Dans ces modes de réalisation, chaque dispositif comprend un ilot 2, 2A, 2B, 2C à base de GaN, et des contacts 31, 32, 33 sur la face supérieure 200 de l'ilot 2A, 2B, 2C.

Les dispositifs sont portés par un substrat 1 qui est typiquement de type GaN sur silicium. Le substrat 1 peut ainsi comprendre de façon connue une partie 10 massive en silicium et une ou plusieurs couches 11 à base de GaN et/ou d'AlGaN. Les couches 11 peuvent être des couches tampon et/ou de germination.

Les ilots 2A, 2B, 2C surmontent le substrat 1, en saillie des couches 11 tampon. Ils forment des structures en mésa séparées et isolées les unes des autres. Les ilots 2A, 2B, 2C sont typiquement en relation d'épitaxie avec la ou les couches 11 sous-jacentes. Ils sont à base d'une ou plusieurs couches de GaN épitaxiées. Ils peuvent comprendre du GaN dopé au carbone GaN:C, qui améliore la tenue en tension des dispositifs, de façon connue. Ils comprennent au moins une partie superficielle en GaN non intentionnellement dopée. Selon une possibilité, les ilots 2A, 2B, 2C ne comprennent pas de carbone, contrairement à ce qui est généralement préconisé. Cela permet d'améliorer la résistance dynamique à l'état passant des dispositifs.

Les ilots 2A, 2B, 2C présentent typiquement une hauteur selon z de plusieurs micromètres, par exemple comprise entre 5 µm et 25 µm. De telles épaisseurs de GaN permettent avantageusement de réaliser des dispositifs de puissance présentant une tension de fonctionnement élevée. Plus l'épaisseur de GaN augmente, plus la tension de claquage augmente et plus la tension de fonctionnement est élevée. Une épaisseur de GaN de 10 µm permet typiquement une tension de fonctionnement du dispositif de l'ordre de 1200 V. Une épaisseur de GaN de 20 µm permet typiquement une tension de fonctionnement du dispositif de l'ordre de 2200 V.

Les ilots 2A, 2B, 2C présentent une dimension selon y de plusieurs dizaines ou centaines de micromètres, par exemple comprise entre 50 µm et 500 µm, typiquement de l'ordre de 200 µm. Les ilots 2A, 2B, 2C sont délimités dans le plan xy par des flancs 201 rejoignant les bords 202. Les ilots 2A, 2B, 2C peuvent typiquement présenter une forme hexagonale, dans le plan xy. Cette forme peut être obtenue naturellement lors de la croissance par épitaxie de GaN, qui présente une structure cristallographique hexagonale. La forme hexagonale permet avantageusement de paver la surface du substrat 1 de façon compacte. Une distance de séparation de l'ordre de 8 à 10 µm, entre les flancs 201 de deux ilots 2A, 2B adjacents, est typiquement réalisable. Cela permet de couvrir environ 95% de la surface du substrat 1. La densité d'intégration des ilots 2A, 2B, 2C peut ainsi être élevée. D'autres formes d'ilots 2A, 2B, 2C, par exemple carré ou polyédrique, sont néanmoins possibles.

Une couche barrière 22, typiquement à base d'AlGaN, est de préférence disposée sur la face supérieure 200 de chaque ilot 2A, 2B, 2C. Cette couche barrière 22 présente une épaisseur par exemple comprise entre 20 nm et 100 nm. La couche barrière 22 présente une portion principale au sommet de l'ilot. Cette portion principale est typiquement orientée selon des plans cristallographiques polaires de la structure hexagonale. Cela permet de former de façon connue un gaz bidimensionnel d'électrons sous la portion principale de la couche barrière 22 à base d'AlGaN, dans l'ilot 2 à base de GaN sous-jacent. Le gaz bidimensionnel d'électrons 2DEG est typiquement confiné à l'interface entre la couche barrière 22 à base d'AlGaN et l'ilot 2 à base de GaN. Ce gaz 2DEG peut être avantageusement exploité dans le cadre des dispositifs de puissance. La couche barrière 22 peut également présenter des portions de couche 22 situées sur les flancs 201. Ces portions sont typiquement orientées selon des plans cristallographiques semi-polaires de la structure hexagonale.

Dans le premier mode de réalisation (figures 1A, 1B), chaque dispositif comprend des premier et deuxième contacts 31, 32 sur la face supérieure 200 de l'ilot 2A, 2B, 2C. Chaque dispositif comprend ainsi au moins une diode Schottky latérale formée entre les contacts 31, 32. Les premiers contacts 31 correspondent ici à des cathodes et les deuxièmes contacts 32 correspondent ici à des anodes. Les anodes 32 forment un contact Schottky avec le GaN de l'ilot 2. Les cathodes 31 et les anodes 32 peuvent être disposées à la surface de la couche barrière 22. Alternativement, les cathodes 31 et/ou les anodes 32 peuvent traverser partiellement ou complètement la couche barrière 22.

Comme illustré aux figures 1A, 1B, au moins une anode 32 est disposée au bord 202 de la surface supérieure 200 de chaque ilot 2. De façon préférée, cette anode 32 forme un contour fermé le long du bord 202, comme illustré en figure 1A. L'anode 32 peut ainsi entourer la cathode 31. L'injection du courant est ainsi mieux répartie. Cela permet d'optimiser le transport du courant. La disposition de l'anode 32 le long du bord 202 permet avantageusement d'appliquer une même polarisation à l'anode 32 et au substrat 1. Cela permet avantageusement de limiter ou supprimer les courants de fuite. La ou les portions de couche barrière 22 à base d'AlGaN situées sur les flancs 201 limitent également l'apparition de courants de fuite. Cela est dû à l'orientation cristallographique de l'AlGaN sur les flancs 201, qui ne présente pas de propriétés de conduction électrique. La tension de claquage du dispositif est augmentée.

Dans l'exemple illustré, chaque dispositif comprend plusieurs anodes 32 et cathodes 31 disposées de façon concentrique sur la surface supérieure 200 de l'ilot 2. En particulier, une anode 32a « centrale » est ici disposée au centre de l'ilot ; une cathode 31a entoure cette anode centrale 32a ; une anode 32b entoure la cathode 31a ; une cathode 31b entoure l'anode 32b ; une anode 32c, coïncidant sensiblement avec le bord 202, entoure la cathode 31b. Dans l'exemple illustré, chaque dispositif comprend ainsi quatre diodes de puissance concentriques interconnectées en parallèle.

Les cathodes 31 peuvent être reliées aux pistes métalliques 310 par l'intermédiaire de vias 311, de façon classique. Les anodes 32 peuvent être reliées aux pistes métalliques 320 par l'intermédiaire de vias 321, de façon classique. Les pistes métalliques 310, 320 connectant les différentes diodes des différents dispositifs peuvent être interdigitées.

Une couche d'encapsulation diélectrique 4 permet d'isoler les diodes entre elles et de faciliter l'intégration des dispositifs, de façon connue. Cette couche d'encapsulation diélectrique 4 remplit typiquement l'espace entre les flancs 201 de deux ilots 2A, 2B adjacents. L'isolation entre deux dispositifs adjacents est améliorée.

Dans le deuxième mode de réalisation (figures 2A, 2B), chaque dispositif comprend au moins un premier contact 31, au moins un deuxième contact 32, et au moins un troisième contact 33 intercalé entre les premier et deuxième contacts 31, 32. Les premier, deuxième et troisième contacts 31, 32, 33 sont disposés sur la face supérieure 200 de l'ilot 2A, 2B, 2C. Les caractéristiques et avantages décrits pour le premier mode de réalisation s'appliquent également à ce deuxième mode de réalisation, mutatis mutandis. Seules les caractéristiques qui diffèrent du premier mode de réalisation sont détaillées ci-après.

En particulier, dans ce deuxième mode de réalisation, chaque dispositif comprend au moins un transistor de puissance latéral, de type HEMT. Les premiers contacts 31 correspondent ici à des drains et les deuxièmes contacts 32 correspondent ici à des sources. Les troisièmes contacts 33 correspondent ici aux grilles des transistors HEMT latéraux.

Dans l'exemple illustré aux figures 2A, 2B, chaque ilot de dispositif comprend quatre transistors de puissance HEMT concentriques interconnectés en parallèle.

De la même façon que pour le premier mode de réalisation, une source 32 est disposée le long du bord 202 de la surface supérieure 200 de chaque ilot 2. Cela permet avantageusement d'appliquer une même polarisation à la source 32 et au substrat 1. La tension de claquage du dispositif est augmentée.

Les drains 31 peuvent être reliés aux pistes métalliques 310 par l'intermédiaire de vias 311, comme précédemment. Les sources 32 peuvent être reliées aux pistes métalliques 320 par l'intermédiaire de vias 321, comme précédemment. Les grilles 33 peuvent être reliées aux pistes métalliques 330 par l'intermédiaire de vias 331, de façon classique. Les pistes métalliques 310, 320 connectant les différents transistors des différents dispositifs peuvent être interdigitées. Les pistes métalliques 330 connectant les grilles des différents transistors peuvent être situées sur un niveau de métal différent de celui sur lequel sont situées les pistes métalliques 310, 320.

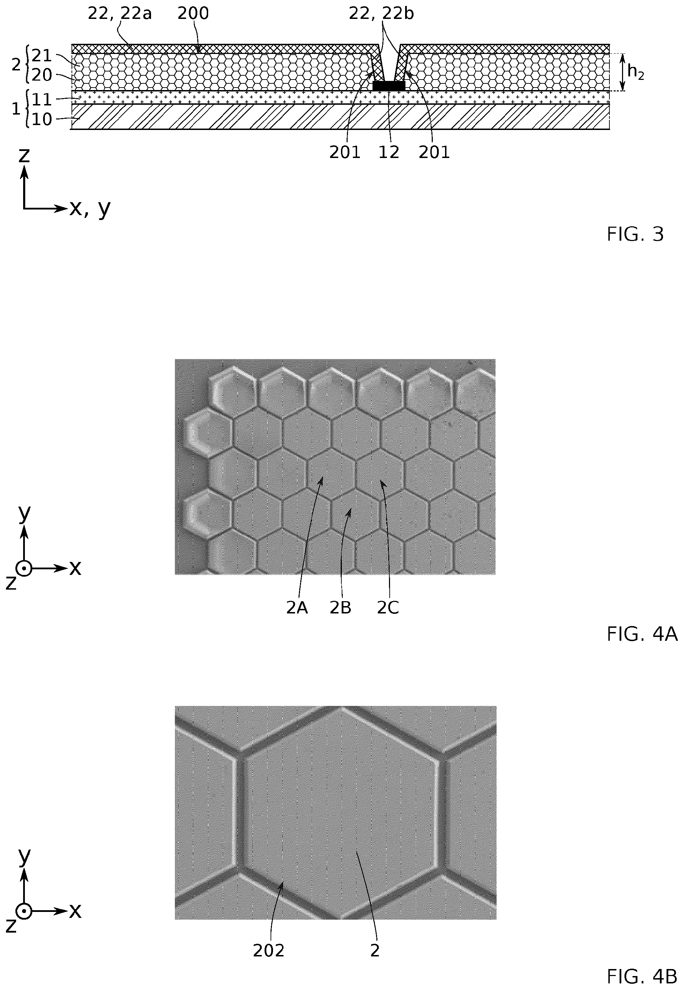

Les figures 3 et 5 à 16 illustrent schématiquement différentes étapes de fabrication de dispositifs de puissance selon le deuxième mode de réalisation, comprenant des transistors HEMT latéraux.

Comme illustré à la figure 3, une première étape consiste à former les ilots 2 sur le substrat 1. La formation des ilots 2 est avantageusement réalisée par épitaxie localisée de GaN sur les couches 11. L'épitaxie localisée est également connue sous les acronymes SAE ou SAG (« Selective Area Epitaxy » ou « Selective Area Growth »). Un masque 12 est formé, par exemple par lithographie, sur les couches 11. L'épitaxie de GaN se fait sur les zones exposées des couches 11. Une pluralité d'ilots 2 adjacents, délimités par le masque 12, est ainsi formée. Le GaN peut être dopé au cours d'une ou plusieurs phases de l'épitaxie. Selon un exemple, une première couche 20 à base de GaN:C peut être formée par épitaxie, suivi d'une deuxième couche 21 à base de GaN non intentionnellement dopé. L'ilot 2 comprend ainsi les première et deuxième couches 20, 21. La première couche 20 peut présenter une épaisseur de plusieurs micromètres, par exemple de l'ordre de 7 µm. La deuxième couche 21 peut présenter une épaisseur de quelques centaines de nanomètres, par exemple de l'ordre de 400 nm. La première couche 20 est cependant uniquement optionnelle. Une unique couche 21 épaisse à base de GaN non intentionnellement dopé peut être épitaxiée pour former l'ilot 2. D'autres couches à base de GaN peuvent également être envisagées pour former l'ilot 2. A l'issue de la ou des épitaxies successives, l'ilot 2 présente une hauteur h2 avantageusement supérieure à 5 µm, par exemple de l'ordre de 10 µm ou 20 µm. Cela permet d'améliorer la tenue en tension des dispositifs réalisés ultérieurement sur ces ilots 2.

Une couche barrière 22 à base d'AlGaN peut ensuite être formée par épitaxie sur chacun des ilots 2. Cette couche barrière 22 présente typiquement une concentration en aluminium comprise entre 20% et 30%at. Elle peut présenter une épaisseur de quelques dizaines de nanomètres, par exemple de l'ordre de 20 nm. La couche barrière 22 comprend typiquement des parties principales 22a sur les sommets des ilots 2, et des parties 22b semi-polaires sur les flancs 201 des ilots 2. Les parties 22b semi-polaires peuvent prendre appui sur le masque 12. D'autres couches, non représentées, peuvent être réépitaxiées sur la couche barrière 22. Dans le cadre de transistors à grille en GaN p, une couche à base de GaN p de 100 nm d'épaisseur peut typiquement être formée sur la couche barrière 22.

Les figures 4A, 4B correspondent à des images de microscopie électronique à balayage réalisées à l'issue de la formation par épitaxie localisée des ilots 2, 2A, 2B, 2C à base de GaN, avant formation de la couche barrière 22. Les ilots 2, 2A, 2B, 2C vus de dessus présentent une forme hexagonale bien définie, avec une dimension selon x de l'ordre de 200 µm. Les ilots hexagonaux 2, 2A, 2B, 2C sont densément répartis sur la surface du substrat 1.

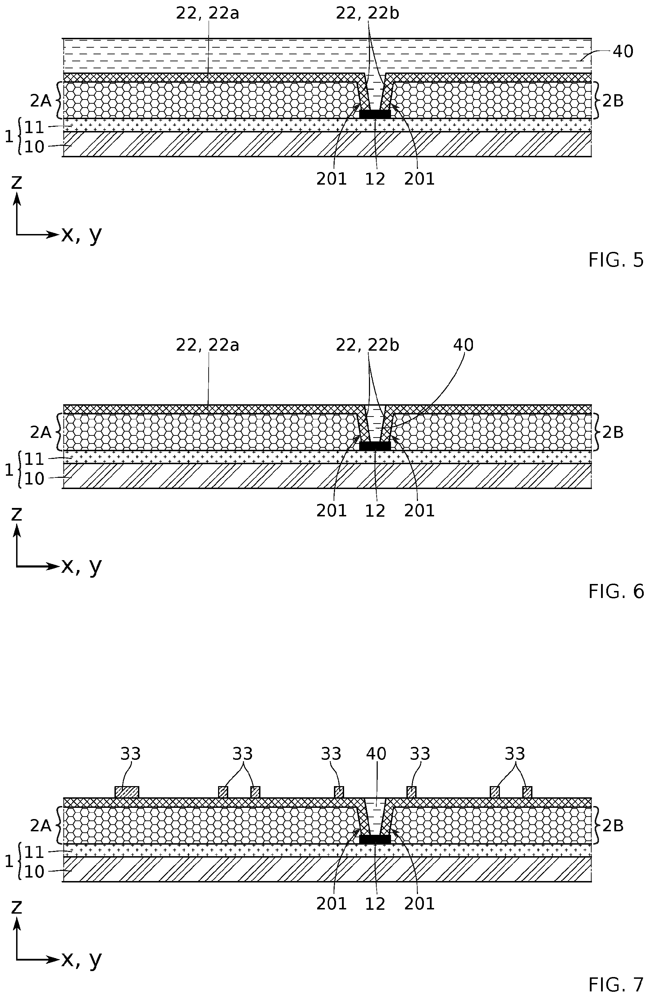

Comme illustré à la figure 5, après formation des ilots 2A, 2B, de la couche barrière 22 et des couches supérieures éventuelles, une couche de remplissage 40 est déposée sur l'ensemble des ilots 2A, 2B. Une couche d'arrêt intercalaire (non illustrée), par exemple à base de SiN de 20 nm d'épaisseur, est de préférence formée préalablement au dépôt de la couche de remplissage 40. Cela permet de faciliter le retrait partiel ultérieur de la couche 40. La couche de remplissage 40 est de préférence à base de SiO2. Elle est par exemple formée par dépôt chimique en phase vapeur basse pression SACVD (acronyme de « Sub-Atmospheric Chemical Vapor Deposition ») à partir d'un précurseur TEOS (acronyme de « Tetraethyl orthosilicate »), avantageusement avec un faible niveau de contrainte résiduelle. Le détail de ce type de procédé de dépôt connu peut être trouvé par exemple dans le document « C. Chang et al., Microsystem Technologies 10 (2004) 97-102 Springer-Verlag 2004 ». La couche de remplissage 40 permet notamment de combler les espaces entre les flancs 201 des ilots 2A, 2B.

Comme illustré à la figure 6, l'épaisseur en excès de la couche de remplissage 40 est ensuite retirée, par exemple et de façon connue par polissage mécano-chimique CMP avec arrêt sur la couche d'arrêt à base de SiN. Seules les parties de la couche 40 situées entre les flancs 201 des ilots 2A, 2B sont conservées à l'issue du procédé CMP.

Comme illustré à la figure 7, les grilles 33 peuvent ensuite être formées en surface des ilots 2A, 2B. Les grilles 33 peuvent résulter d'une gravure de la couche à base de GaN p présente sur la couche barrière 22 (cas des transistors à grille en GaN p). Alternativement, les grilles 33 peuvent être formées par dépôt d'un métal de grille suivi d'étapes de lithographie/gravure. Selon une possibilité, des tranchées peuvent être préalablement formées au travers de la couche barrière 22, jusque dans le GaN des ilots 2A, 2B, puis tapissées par un diélectrique de grille avant dépôt du métal de grille dans les tranchées. Des grilles enterrées ou semi-enterrées peuvent ainsi être réalisées (cas des transistors MOS à grille enterrée). D'autres structures de grille 33 peuvent être envisagées, en fonction des architectures de transistors latéraux visées.

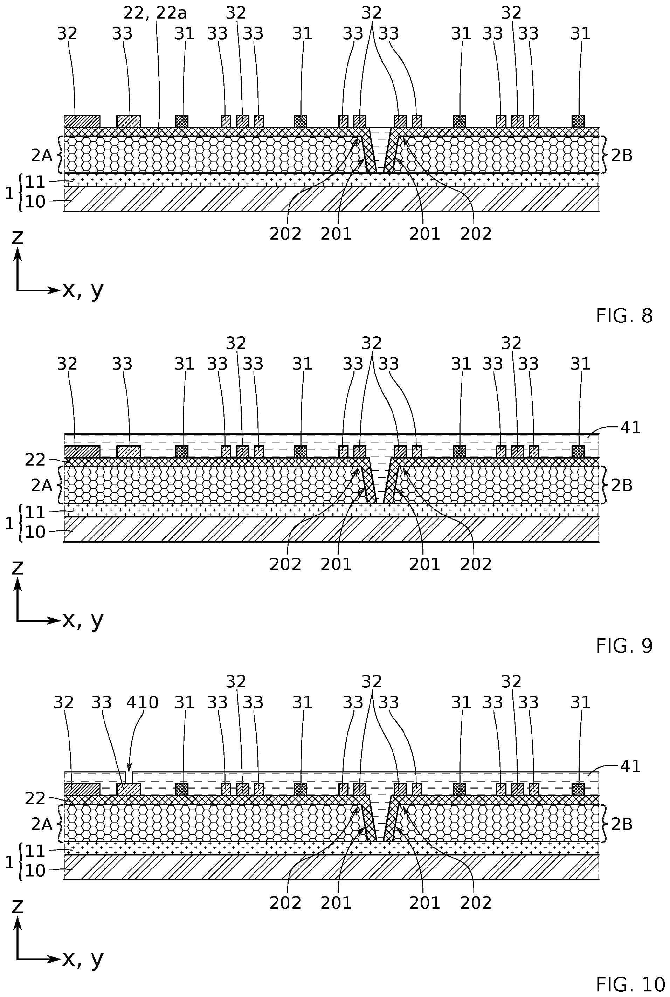

Comme illustré à la figure 8, les contacts de source 32 et drain 31 sont ensuite formés de part et d'autre des grilles 33. La formation des sources et drains 31, 32 peut se faire de façon classique par dépôt Ti/Al suivi d'un recuit et de lithographie/gravure.

Comme illustré à la figure 9, une couche 41 à base de SiO2 est ensuite déposée pour isoler les contacts 31, 32, 33 entre eux. Une étape de planarisation par CMP est de préférence également effectuée.

Comme illustré à la figure 10, des ouvertures de vias 410 sont ensuite formées par gravure de la couche 41 à l'aplomb des grilles 33.

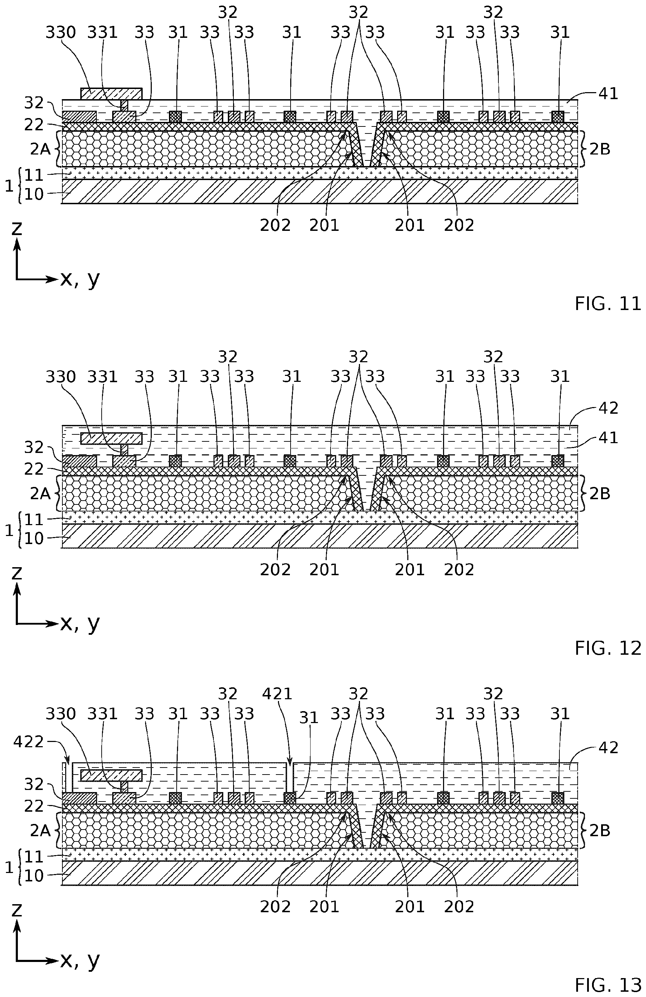

Comme illustré à la figure 11, les ouvertures de vias 410 sont ensuite remplies par un métal pour former les vias 331. Des pistes métalliques 330 connectant les vias 331 sont également formées à la surface de la couche 41. La formation des vias 331 et des pistes métalliques 330 peut se faire par une seule étape de dépôt métallique, suivie de lithographie/gravure pour définir les pistes métalliques 330.

Comme illustré à la figure 12, une couche 42 à base de SiO2 est ensuite déposée sur la couche 41 et sur les pistes métalliques 330, pour isoler les pistes métalliques 330. Une étape de planarisation par CMP est de préférence également effectuée.

Comme illustré à la figure 13, des ouvertures de vias 421 sont ensuite formées par gravure des couches 42, 41 à l'aplomb des drains 31. Des ouvertures de vias 422 sont également formées par gravure des couches 42, 41 à l'aplomb des sources 32.

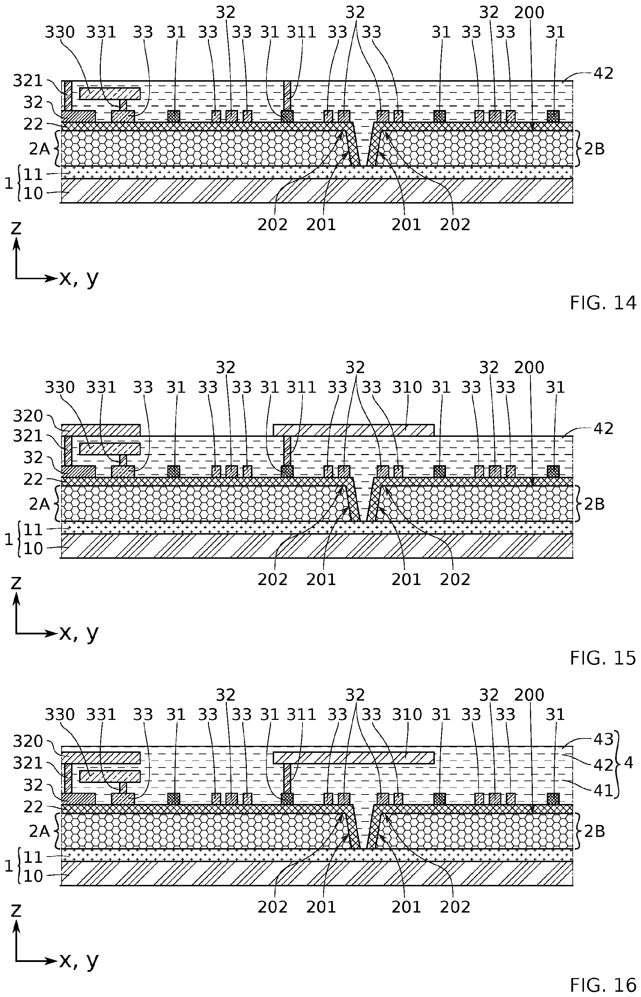

Comme illustré à la figure 14, les ouvertures de vias 421, 422 sont ensuite remplies par un métal pour former les vias 311, 321, respectivement. Les vias 311 connectent les drains 31, et les vias 321 connectent les sources 32. L'excès de métal peut être retiré par CMP avant formation des pistes métalliques 310, 320.

Comme illustré à la figure 15, des pistes métalliques 310, 320 connectant respectivement les vias 311, 321 sont ensuite formées à la surface de la couche 42. Selon une possibilité, lorsque la hauteur ou le rapport de forme des vias 311, 321 le permet, la formation des vias 311, 321 et des pistes métalliques 310, 320 peut se faire par une seule étape de dépôt métallique, suivie de lithographie/gravure pour définir les pistes métalliques 310, 320.

Comme illustré à la figure 16, une couche 43 à base de SiO2 est ensuite déposée sur la couche 42 et sur les pistes métalliques 310, 320, pour isoler les pistes métalliques 310, 320. Une étape de planarisation par CMP est de préférence également effectuée.

Des dispositifs de puissance, ici des transistors HEMT latéraux concentriques, sont ainsi avantageusement formés sur les ilots 2A, 2B. La tenue en tension de ces dispositifs de puissance est améliorée. La fabrication et l'intégration de ces dispositifs de puissance peuvent être avantageusement effectuées par des procédés standards de l'industrie microélectronique. L'invention n'est pas limitée aux modes de réalisations précédemment décrits.

## Revendications

1. Dispositif microélectronique comprenant :
- Un substrat (1) à base d'au moins un matériau semiconducteur,
- Un ilot (2) à base de nitrure de gallium GaN surmontant le substrat, en saillie, et présentant une face (200) dite supérieure et des flancs (201) entourant l'ilot,
- Au moins un premier contact (31), par exemple un drain ou une cathode, sur la face supérieure (200) de l'ilot (2),
- Au moins un deuxième contact (32), par exemple une source ou une anode,
le dispositif étant **caractérisé en ce que** l'au moins un deuxième contact (32) est disposé sur la face supérieure (200) de l'ilot (2) et le long d'un bord (202) de ladite face supérieure (200), de sorte que l'au moins un deuxième contact (32) entoure au moins partiellement l'au moins un premier contact (31), et **en ce que** l'au moins un deuxième contact (32) et le substrat (1) sont configurés pour être polarisés selon une même polarisation lors d'un fonctionnement du dispositif.

2. Dispositif selon la revendication précédente comprenant en outre une couche barrière (22), par exemple à base d'AlGaN, sur la face supérieure (200) de l'ilot (2).

3. Dispositif selon la revendication précédente dans lequel l'au moins un premier contact (31) et l'au moins un deuxième contact (32) sont disposés sur la couche barrière (22).

4. Dispositif selon l'une quelconque des revendications précédentes dans lequel l'au moins un deuxième contact (32) entoure totalement l'au moins un premier contact (31) et forme un contour fermé autour de l'au moins un premier contact (31).

5. Dispositif selon l'une quelconque des revendications précédentes comprenant une pluralité de premiers contacts (31) et une pluralité de deuxièmes contacts (32), les premiers et deuxièmes contacts (31, 32) étant disposés de façon concentrique sur la face supérieure (200) de l'ilot (2).

6. Dispositif selon l'une quelconque des revendications précédentes dans lequel les premier et deuxième contacts (31, 32) correspondent respectivement à une cathode et à une anode, et le deuxième contact (32) forme un contact Schottky avec l'ilot (2), de sorte que le dispositif comprend au moins une structure de type diode Schottky.

7. Dispositif selon la revendication précédente comprenant au moins une première anode (32a) au centre de l'ilot et, de façon concentrique, une première cathode (31a) entourant totalement la première anode (32a), une deuxième anode (32b) entourant totalement la première cathode (31a), une deuxième cathode (31b) entourant totalement la deuxième anode (32b), et une troisième anode (32c) disposée le long du bord (202) de la face supérieure (200) de l'ilot et entourant totalement la deuxième cathode (31b), de sorte que le dispositif comprend quatre diodes Schottky latérales concentriques, interconnectés en parallèle.

8. Dispositif selon l'une quelconque des revendications 1 à 5 comprenant au moins un troisième contact (33), par exemple une grille, disposé sur la face supérieure (200) de l'ilot (2) entre l'au moins un premier contact (31) et l'au moins un deuxième contact (32), de sorte que le dispositif comprend au moins une structure de type transistor.

9. Dispositif selon la revendication précédente comprenant une pluralité de premiers, deuxièmes et troisièmes contacts (31, 32, 33) disposés de façon concentrique sur la face supérieure (200) de l'ilot, de sorte que le dispositif comprend au moins deux transistors latéraux en parallèle interconnectés via au moins l'un parmi les premiers et deuxièmes contacts (31, 32).

10. Dispositif selon l'une quelconque des revendications précédentes dans lequel le bord (202) de l'ilot forme un contour hexagonal pour la face supérieure (200) de l'ilot.

11. Système comprenant une pluralité de dispositifs selon l'une quelconque des revendications précédentes, adjacents les uns les autres, dans lequel le substrat (1) est commun à tous les dispositifs et les ilots (2A, 2B, 2C) des dispositifs sont séparés les uns des autres par une distance inférieure à 10 µm, entre deux flancs (201) de deux ilots (2A, 2B) adjacents.

12. Système selon la revendication précédente dans lequel les ilots (2A, 2B, 2C) présentent une forme hexagonale, et sont disposés sur le substrat (1) selon un pavage hexagonal.

13. Procédé de fabrication d'au moins un dispositif selon l'une quelconque des revendications 1 à 10, comprenant les étapes suivantes :
- Former par épitaxie localisée au moins un ilot (2A, 2B, 2C) à base de GaN sur un substrat (1) à base d'au moins un matériau semiconducteur,
- Former au moins un premier contact (31) sur la face supérieure (200) dudit au moins un ilot,
- Former au moins un deuxième contact (32) sur la face supérieure (200), en bordure dudit au moins un ilot (2A, 2B, 2C).

14. Procédé selon la revendication précédente dans lequel la formation par épitaxie localisée est configurée de manière à ce que l'au moins un ilot (2A, 2B, 2C) présente une hauteur h2 supérieure ou égale à 5 µm, de préférence supérieure ou égale à 10 µm.

15. Procédé selon l'une quelconque des deux revendications précédentes dans lequel l'au moins un ilot comprend une pluralité d'ilots (2A, 2B, 2C) séparés les uns des autres par une distance inférieure à 10 µm, entre deux flancs (201) de deux ilots adjacents (2A, 2B).
